# EUROPÄISCHE PATENTSCHRIFT

(11) **EP 3 520 122 B1**
(45) Veröffentlichungstag und Bekanntmachung des Hinweises auf die Patenterteilung: **12.04.2023**
(21) Anmeldenummer: 17772416.8
(22) Anmeldetag: 26.09.2017
(51) Int. Cl.: H01B 7/32, H01B 7/42, B60L 53/18

(54) **ELEKTRISCHES KABEL MIT EINER KÜHLMITTELLEITUNG**
ELECTRIC CABLE HAVING A COOLANT LINE
CÂBLE ÉLECTRIQUE ÉQUIPÉ D'UNE CONDUITE DE RÉFRIGÉRANT

(30) Priorität: 27.09.2016 DE 102016118193
(43) Veröffentlichungstag der Anmeldung: 07.08.2019
(73) Patentinhaber: Phoenix Contact e-Mobility GmbH, 32816 Schieder-Schwalenberg (DE)
(72) Erfinder: FÜHRER, Thomas, 32825 Blomberg (DE)
(74) Vertreter: Meyer-Graefe, Karsten
(86) Internationale Anmeldenummer: PCT/EP2017/074272
(87) Internationale Veröffentlichungsnummer: WO 2018/060152

(56) Entgegenhaltungen:
- DE-A1- 2 752 290
- DE-A1- 2 940 193
- DE-A1- 3 908 903
- DE-A1-102011 100 389
- US-A- 5 591 937

## Beschreibung

Die Erfindung betrifft ein Kabel zum Übertragen eines elektrischen Stroms nach dem Oberbegriff des Anspruchs 1.

Ein derartiges Kabel umfasst einen Kabelschlauch, zumindest eine in dem Kabelschlauch erstreckte elektrische Lastleitung zum Leiten eines elektrischen Stroms und zumindest eine in dem Kabelschlauch erstreckte Kühlmittelleitung zum Führen eines Kühlmittels.

Ein solches Kabel kann insbesondere als Ladekabel zum Aufladen eines elektrisch angetriebenen Fahrzeugs (auch bezeichnet als Elektrofahrzeug) Verwendung finden. In diesem Fall kann das Kabel beispielsweise einerseits an eine Ladestation angeschlossen sein und andererseits ein Steckverbinderteil in Form eines Ladesteckers tragen, der in ein zugeordnetes Gegensteckverbinderteil in Form einer Ladebuchse an einem Fahrzeug eingesteckt werden kann, um auf diese Weise eine elektrische Verbindung zwischen der Ladestation und dem Fahrzeug herzustellen.

Ladeströme können grundsätzlich als Gleichströme oder als Wechselströme übertragen werden, wobei insbesondere Ladeströme in Form von Gleichstrom eine große Stromstärke, beispielsweise größer als 200 A oder sogar größer als 350 A, aufweisen und zu einer Erwärmung des Kabels genauso wie eines mit dem Kabel verbundenen Steckverbinderteils führen können. Dies kann erforderlich machen, das Kabel zu kühlen.

Eine Lösung, um einer solchen Erwärmung an dem Kabel entgegenzuwirken, könnte darin liegen, den Querschnitt der Lastleitung in dem Kabel weiter zu vergrößern. Dies hat jedoch den Nachteil, dass das Kabel insgesamt schwerer und weniger flexibel wird, so dass die Handhabbarkeit des Kabels für einen Nutzer beeinträchtigt sein kann.

Ein aus der DE 10 2010 007 975 B4 bekanntes Ladekabel weist eine Kühlmittelleitung auf, die eine Zuleitung und eine Rückleitung für ein Kühlmittel umfasst und somit einen Kühlmittelfluss hin und zurück in dem Ladekabel ermöglicht. Die Kühlmittelleitung der DE 10 2010 007 975 B4 dient hierbei zum einen zum Abführen von an einem Energiespeicher eines Fahrzeugs entstehender Verlustwärme, zudem aber auch zum Kühlen des Kabels an sich.

Bei einem aus der DE 10 2011 100 389 A1 bekannten Kabel in Form eines Ladekabels zum Aufladen eines Elektrofahrzeugs ist eine Kühlmittelleitung in einem Kabelschlauch verlegt, die einen Vorlauf und einen Rücklauf für ein Kühlmittel bereitstellt, um Wärme an dem Kabel aufzunehmen und von dem Kabel abzuführen.

Bei einem aus der DE 42 08 928 C1 bekannten Energiekabel in Form eines Ein- oder Mehrleiterverbundkabels sind Hohlkanäle vorgesehen, in denen ein Kühlmittel geführt werden kann. In einem Parallelkanal kann zudem beispielsweise ein Nachrichtenleiter oder ein Sensor zum Beispiel in Form eines Lichtwellenleiters zum Erfassen einer Erwärmung vorgesehen sein.

Bei einem Kabel in Form eines Ladekabels, das eine oder mehrere Kühlmittelleitungen aufweist, kann es durch Einknicken des Kabels oder durch ein Überfahren des Kabels durch ein Fahrzeug zu Beschädigungen kommen. Wird auf diese Weise eine Kühlmittelleitung beschädigt, so kann Kühlmittel, zum Beispiel Wasser, aus der Kühlmittelleitung austreten und in das Innere des Kabelschlauchs gelangen. Weil in dem Kabelschlauch generell Zwischenräume vorhanden sein können, kann auf diese Weise Kühlmittel sich in dem Kabelschlauch ausbreiten und beispielsweise hin zu einem mit dem Ladekabel verbundenen Steckverbinderteil oder hin zu einer mit dem Ladekabel verbundenen Ladeeinrichtung strömen, was gefährlich sein kann, weil an einem Steckverbinderteil und an einer Ladeeinrichtung hochspannungsführende Bauelemente vorhanden sind, deren Isolation durch unkontrollierten Zugang eines elektrisch leitfähigen Kühlmittels, zum Beispiel Wasser, gefährdet sein kann.

Das aus der DE 27 52290 A1 bekannte Hochspannungsenergiekabel umfasst ein zentrales Kühlrohr durch das Kühlflüssigkeit geleitet wird, sowie Meldeleitungen, die eine Detektion eines Kühlmittelaustritts aus dem Kühlrohr ermöglichen.

Die DE 29 40193 beschreibt ein Hochspannungskabel mit integrierten Kontroll- und Ortungsadern, die ein Eindringen und Verbreiten von Wasser im Innern des Kabelschlauchs detektieren.

Aufgabe der vorliegenden Erfindung ist es, ein Kabel zum Führen eines elektrischen Stroms bereitzustellen, mittels dessen eine Betriebsgefährdung bei einem Austritt von Kühlmittel aus der in dem Kabelschlauch erstreckten Kühlmittelleitung zumindest reduziert sein kann.

Diese Aufgabe wird durch einen Gegenstand mit den Merkmalen des Anspruchs 1 gelöst. Demnach umfasst das Kabel zumindest eine in dem Kabelschlauch erstreckte, zumindest abschnittsweise nicht elektrisch isolierte, elektrisch leitende Fühlleitung zum Erfassen eines eine Veränderung der elektrischen Leitfähigkeit in dem Kabelschlauch anzeigenden Messsignals.

Demgemäß soll eine Fühlleitung in dem Kabelschlauch verlegt sein, über die ein Messsignal aufgenommen werden kann, das eine Veränderung der elektrischen Leitfähigkeitseigenschaften in dem Kabelschlauch anzeigt. Tritt aus einer Kühlmittelleitung ein zumindest in begrenztem Maße elektrisch leitfähiges Kühlmittel, beispielsweise Wasser, aus, so verändert sich hierdurch zumindest in solchen Bereichen, in die das Kühlmittel strömt, die elektrische Leitfähigkeit. Die zumindest abschnittsweise nicht elektrisch isolierte Fühlleitung kann mit dem Kühlmittel elektrisch in Kontakt kommen, was ermöglicht, über die Fühlleitung beispielsweise durch Messen eines Stroms bei Anlegen einer Spannung ein Messsignal aufzunehmen, was Rückschlüsse auf eine Veränderung der elektrischen Leitfähigkeit in dem Kabelschlauch und somit auf den möglichen Austritt eines Kühlmittels in dem Kabelschlauch zulässt.

Beispielsweise können in dem Kabelschlauch eine erste Fühlleitung und eine von der ersten Fühlleitung beabstandete, zweite Fühlleitung verlegt sein. Zwischen diese Fühlleitungen kann eine Spannungsdifferenz angelegt werden, um durch Messen eines elektrischen Stroms Rückschlüsse auf ein in dem Kabelschlauch ausgetretenes Kühlmittel zu ziehen. Sind die Kühlmittelleitungen intakt und ist kein Kühlmittel ausgetreten, so sind die Fühlleitungen elektrisch voneinander isoliert. Ist Kühlmittel ausgetreten, so kann das Kühlmittel zumindest bereichsweise in dem Kabelschlauch die elektrische Isolation zwischen den Fühlleitungen überbrücken, was anhand des über die Fühlleitungen aufgenommenen Messsignals erkannt werden kann.

Angemerkt sei an dieser Stelle, dass grundsätzlich eine Fühlleitung ausreichend sein kann. So kann beispielsweise über ein an eine Fühlleitung angelegtes Messpotential und einen auf einem Massepotential befindlichen Schirmleiter ein Messsignal aufgenommen werden, dass eine Veränderung der elektrischen Leitfähigkeit in dem Kabelschlauch anzeigt.

Sind zwei Fühlleitungen in dem Kabelschlauch verlegt, so sind diese beabstandet zueinander angeordnet und stehen nicht elektrisch kontaktierend in Berührung miteinander. Die Fühlleitungen sind somit elektrisch voneinander isoliert, wenn die Kühlmittelleitungen funktionsfähig und nicht beschädigt sind und somit kein (elektrisch leitfähiges) Kühlmittel aus den Kühlmittelleitungen ausgetreten ist. Ist Kühlmittel ausgetreten, so kann hierdurch die elektrische Isolation zwischen den Fühlleitungen bereichsweise überbrückt sein, was beispielsweise anhand eines Stromflusses bei zwischen den Fühlleitungen anliegender Spannung erkannt werden kann.

Die Fühlleitungen sind nicht notwendigerweise entlang ihrer gesamten Länge elektrisch nicht isoliert, weisen also keine elektrisch isolierende Ummantelung auf. Ausreichend kann sein, wenn die Fühlleitungen lediglich abschnittsweise elektrisch freiliegen. In solchen Bereichen, die mittels einer elektrischen Ummantelung umhüllt und dadurch isoliert sind, können die Fühlleitungen hierbei auch miteinander in Anlage sein. Entscheidend ist lediglich, dass Fühlleitungen nicht mit elektrisch nicht isolierten Abschnitten kontaktierend miteinander in Berührung stehen und die Fühlleitungen elektrisch voneinander isoliert sind.

In dem Kabel ist eine zentrale, erste Kühlmittelleitung erstreckt, über die beispielsweise ein Zufluss eines Kühlmittels bereitgestellt werden kann. Um diese zentral innerhalb des Kabelschlauchs erstreckte Kühlmittelleitung sind ein oder mehrere zweite Kühlmittelleitungen und zudem ein oder mehrere elektrische Lastleitungen gruppiert, sodass die zweiten Kühlmittelleitungen und die Lastleitungen die zentrale, erste Kühlmittelleitung zwischen sich aufnehmen. Über die zweiten Kühlmittelleitungen kann beispielsweise ein Rückfluss für das Kühlmittel bereitgestellt werden.

Bei Ausgestaltung des Kabels als Ladekabel zum Aufladen eines Elektrofahrzeugs kann über die zentrale, erste Kühlmittelleitung beispielsweise ein Zufluss hin zu einem an dem Kabel angeordneten Steckverbinderteil bereitgestellt werden. Über die zweiten Kühlmittelleitungen kann das Kühlmittel hingegen von Gegensteckverbinderteil zurück zu einer Ladestation strömen, um Wärme von dem Kabel und von dem Steckverbinderteil abzuführen.

Die zumindest eine Fühlleitung ist in einem Zwischenraum zwischen der zentralen, ersten Kühlmittelleitung und der zumindest einen zweiten Kühlmittelleitung und/oder der zumindest einen elektrischen Lastleitung erstreckt. Die zentrale, erste Kühlmittelleitung und auch die zweiten Kühlmittelleitungen und die Lastleitungen weisen eine im Querschnitt zumindest näherungsweise kreisförmige Gestalt auf. Zwischen der zentralen, ersten Kühlmittelleitung, den zweiten Kühlmittelleitungen und den Lastleitungen ergeben sich somit Zwischenräume, in denen eine oder mehrere Fühlleitungen erstreckt sind.

Angemerkt sei an dieser Stelle, dass auch mehr als zwei Fühlleitungen in dem Kabelschlauch verlegt sein können. Beispielsweise kann in jedem Zwischenraum zwischen der zentralen, ersten Kühlmittelleitung, den zweiten Kühlmittelleitungen und den Lastleitungen eine Fühlleitung erstreckt sein, sodass eine räumlich enge Detektion eines Austritts eines Kühlmittels möglich wird. An die Fühlleitungen kann alternierend ein Messpotential und ein Massepotential angelegt werden, sodass sich zwischen benachbarten Fühlleitungen eine Potentialdifferenz ergibt.

Die zumindest eine Fühlleitung ist vorzugsweise an eine Steuereinrichtung angeschlossen, die ausgebildet ist, ein Messpotential an die zumindest eine Fühlleitung anzulegen, um ein eine Veränderung der Leitfähigkeit in dem Kabelschlauch anzeigendes Messsignal zu erfassen. Ist das Kabel als Ladekabel zum Aufladen eines Elektrofahrzeugs ausgebildet, so kann die Steuereinrichtung beispielsweise in eine Ladestation integriert sein, an die das Kabel angeschlossen ist. Über die Steuereinrichtung kann beispielsweise eine Spannung zwischen einer ersten Fühlleitung und einer zweiten Fühlleitung angelegt werden, um anhand der Spannung einen Stromfluss über die Fühlleitungen zu detektieren und daraus auf die elektrischen Leitfähigkeitseigenschaften in dem Kabelschlauch zurückzuschließen.

Über die Steuereinrichtung kann auch die Steuerung eines über die Lastleitung fließenden Laststroms bereitgestellt werden. So kann die Steuereinrichtung ausgebildet sein, einen über die Lastleitung fließenden Strom abzuschalten, wenn eine (unzulässige) Veränderung der Leitfähigkeit in dem Kabelschlauch diktiert wird. Ist das Kabel als Ladekabel zum Aufladen eines Elektrofahrzeugs ausgebildet, so kann über die Steuereinrichtung somit ein Ladevorgang unterbrochen oder gar nicht erst gestartet werden, wenn anhand einer Veränderung der Leitfähigkeit in dem Kabelschlauch eine Beschädigung einer Kühlmittelleitung erkannt wird.

Das Kabel ist vorzugsweise Bestandteil eines Ladesystems zum Aufladen eines Elektrofahrzeugs und ist an einem ersten Ende mit einem Steckverbinderteil, beispielsweise einem Ladestecker, und an seinem anderen, zweiten Ende mit einer Ladestation zum Aufladen eines Elektrofahrzeugs verbunden. Der Kabelschlauch ist vorzugsweise flexibel, sodass das Kabel von der Ladestation in flexibler Weise hin zu einem Elektrofahrzeug verlegt werden kann.

Der der Erfindung zugrunde liegende Gedanke soll nachfolgend anhand der in den Figuren dargestellten Ausführungsbeispiele näher erläutert werden. Es zeigen:
- Fig. 1: eine Ansicht einer Ladestation mit einem daran angeordneten Kabel;
- Fig. 2: eine Ansicht eines Steckverbinderteils des Kabels;
- Fig. 3: eine Ansicht eines Ausführungsbeispiels eines Kabels in Form eines Ladekabels;
- Fig. 4: eine Querschnittsansicht des Kabels;
- Fig. 5: eine schematische Ansicht des Kabels mit darin erstreckten Fühlleitungen;
- Fig. 6: eine schematische Ansicht des Kabels und der darin erstreckten Fühlleitungen, bei Austritt eines Kühlmittels aus einer Kühlmittelleitung; und
- Fig. 7: eine schematische Ansicht eines anderen Ausführungsbeispiels eines Kabels mit darin erstreckten Fühlleitungen.

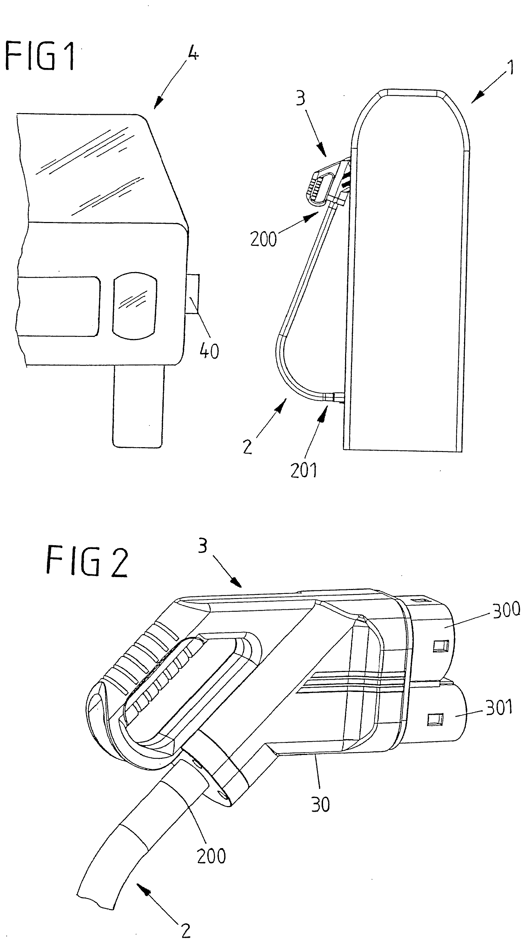

Fig. 1 zeigt eine Ladestation 1, die zum Aufladen eines elektrisch angetriebenen Fahrzeugs 4, auch bezeichnet als Elektrofahrzeug, dient. Die Ladestation 1 ist dazu ausgestaltet, einen Ladestrom in Form eines Wechselstroms oder eines Gleichstroms zur Verfügung zu stellen und weist ein Kabel 2 auf, das mit einem Ende 201 mit der Ladestation 1 und mit einem anderen Ende 200 mit einem Steckverbinderteil 3 in Form eines Ladesteckers verbunden ist.

Wie aus der vergrößerten Ansicht gemäß Fig. 2 ersichtlich, weist das Steckverbinderteil 3 an einem Gehäuse 30 Steckabschnitte 300, 301 auf, mit denen der Steckverbinderteil 3 steckend mit einem zugeordneten Gegensteckverbinderteil 40 in Form einer Ladebuchse an dem Fahrzeug 4 in Eingriff gebracht werden kann. Auf diese Weise kann die Ladestation 1 elektrisch mit dem Fahrzeug 4 verbunden werden, um Ladeströme von der Ladestation 1 hin zu dem Fahrzeug 4 zu übertragen.

Um ein zügiges Aufladen des Elektrofahrzeugs 4 zu ermöglichen, weisen die übertragenen Ladeströme eine große Stromstärke, z.B. größer als 200 A, gegebenenfalls sogar in der Größenordnung von 350 A oder darüber, auf. Aufgrund solch hoher Ladeströme kommt es an den Leitungen des Kabels 2 zu thermischen Verlusten, die zu einem Erwärmen des Kabels 2 führen können. Bei den an einer Ladestation 1 heutzutage verwendeten Stromstärken können beispielsweise thermische Verluste im Bereich von 150 W pro Meter des Kabels 2 oder gar mehr auftreten, was mit einer erheblichen Erwärmung an dem Kabel 2 einhergehen kann.

Einer großen Stromstärke könnte generell durch Verwenden von elektrischen Leitungen mit großem Leitungsquerschnitt begegnet werden. Dies erhöht jedoch nicht nur die Kosten des Kabels 2, sondern beeinträchtigt zudem die Handhabbarkeit des Kabels 2, weil mit dem Leitungsquerschnitt auch das Gewicht der Leitungen und damit des Kabels 2 steigt. Es besteht daher ein Bedürfnis nach einer aktiven Kühlung des Kabels 2, mit der eine übermäßige Erwärmung des Kabels 2 vermieden werden kann, ohne dass hierzu zwingend eine übermäßige Vergrößerung des Leitungsquerschnitts der in dem Kabel 2 verlegten Leitungen erforderlich ist.

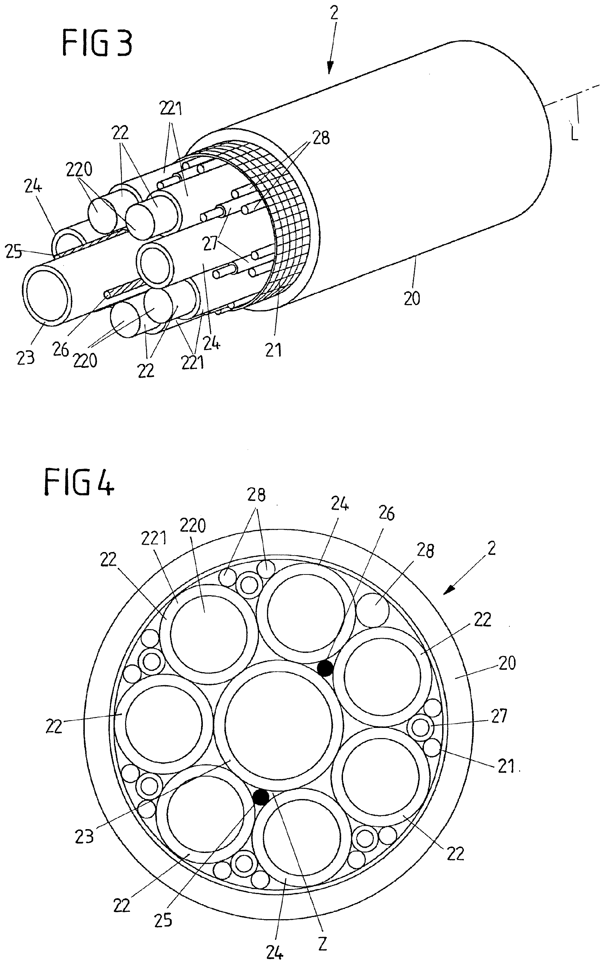

Bei einem in Fig. 3 dargestellten Ausführungsbeispiel eines Kabels 2 sind daher in einem Kabelschlauch 20 Kühlmittelleitungen 23, 24 verlegt, die einen Kühlmittelfluss innerhalb des Kabels 2 bereitstellen und auf diese Weise Wärme an den in dem Kabelschlauch 20 erstreckten Lastleitungen 22 aufnehmen und abführen können.

Wie aus Fig. 3 und der Querschnittansicht gemäß Fig. 4 ersichtlich, weist das Kabel 2 einen äußeren Kabelschlauch 20 aus einem elektrisch isolierenden, flexiblen Material auf, an dessen Innenseite ein Schirmleiter 21 angeordnet ist. Der Schirmleiter 21 befindet sich auf einem elektrischen Massepotential und dient zur elektromagnetischen Abschirmung der in den Kabelschlauch 20 erstreckten Lastleitungen 22 nach außen hin.

Im Inneren des Kabelschlauchs 20 ist eine Mehrzahl von Lastleitungen 22 verlegt, die zum Übertragen eines Wechselstroms oder eines Gleichstroms dienen können und auf Seiten des Steckverbinderteils 3 mit Kontaktelementen an den Steckabschnitten 300, 301 verbunden sind. Jede Lastleitung 22 weist eine elektrisch leitende Leitungsader 220 auf, die von einer elektrisch isolierenden Ummantelung 221 umhüllt ist. Über die Lastleitungen 22 werden Lastströme hin zum Steckverbinderteil 3 übertragen, sodass bei an die Ladebuchse 40 auf Seiten des Elektrofahrzeugs angeschlossenem Steckverbinderteil 3 Ladeströme zum Aufladen des Elektrofahrzeugs 4 übertragen werden können.

Das Kabel 2 weist, wie insbesondere aus der Querschnittansicht gemäß Fig. 4 ersichtlich, eine zentrale, erste Kühlmittelleitung 23 auf, die beispielsweise einen Zufluss von Kühlmittel hin zum Steckverbinderteil 3 bereitstellt. Um die zentrale, erste Kühlmittelleitung 23 herum sind die Lastleitungen 22 sowie zwei zweite Kühlmittelleitungen 24 gruppiert, über die beispielsweise ein Rückfluss des Kühlmittels von dem Steckverbinderteil 3 zurück zur Ladestation 1 bereitgestellt werden kann. Zudem sind Signalleitungen 27 in dem Kabelschlauch 20 eingefasst, über die Steuersignale von der Ladestation 1 hin zum Steckverbinderteil 3 und umgekehrt übertragen werden können. Füllelemente 28 dienen dazu, das Innere des Kabelschlauchs 20 derart auszufüllen, dass der Kabelschlauch 20 im Querschnitt eine zumindest näherungsweise kreisförmige Gestalt einnimmt, wie dies aus Fig. 4 ersichtlich ist.

Das Kabel 2 ist entlang einer Längsachse L erstreckt, dabei aber flexibel biegbar. Die zentrale, erste Kühlmittelleitung 23 ist koaxial zu der Längsachse L. Die Lastleitungen 22 und die zweiten Kühlmittelleitungen 24 sind um die Längsachse L herum umfänglich an der zentralen, ersten Kühlmittelleitung 23 verteilt.

Die zentrale, erste Kühlmittelleitung 23, die zweiten Kühlmittelleitungen 24 und die Lastleitungen 22 weisen im Querschnitt eine jeweils zumindest näherungsweise kreisförmige Gestalt auf, wie dies aus Fig. 4 ersichtlich ist. Zwischen der zentralen, ersten Kühlmittelleitung 23, den zweiten Kühlmittelleitungen 24 und den Lastleitungen 22 ergeben sich somit Zwischenräume Z. In diesen Zwischenräumen Z sind, bei dem Ausführungsbeispiel gemäß Fig. 3 und 4, zwei Fühlleitungen 25, 26 verlegt, die sich längs innerhalb des Kabelschlauchs 20 erstrecken und jeweils mit der zentralen Kühlmittelleitung 23, einer der zweiten Kühlmittelleitungen 24 und einer Lastleitung 22 in Anlage sind. Die Fühlleitungen 25, 26 sind zumindest abschnittsweise elektrisch nicht isoliert, vorzugsweise entlang ihrer gesamten Länge innerhalb des Kabelschlauchs 20. Die elektrisch leitenden Leiter der Fühlleitungen 25, 26 liegen somit innerhalb des Kabelschlauchs 20 frei, sind dabei aber voneinander beabstandet und elektrisch nicht miteinander kontaktiert, sodass die Fühlleitungen 25, 26 in einem normalen Gebrauchszustand des Kabels 2 elektrisch voneinander isoliert sind.

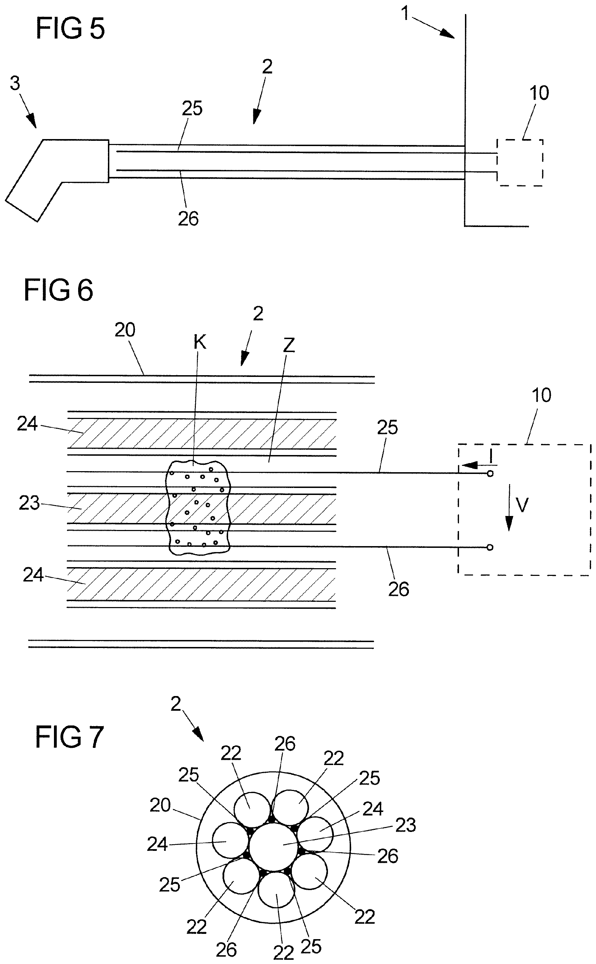

Die Fühlleitungen 25, 26 sind, wie dies schematisch in Fig. 5 dargestellt ist, auf Seiten der Ladestation 1 mit einer Steuereinrichtung 10 verbunden. Über die Fühlleitungen 25, 26 kann detektiert werden, wenn sich innerhalb des Kabelschlauchs 20 aufgrund eines Austretens von Kühlmittel aus einer der Kühlmittelleitungen 23, 24 zum Beispiel bei einer Beschädigung einer der Kühlmittelleitung 23, 24 eine Veränderung der elektrischen Leitfähigkeit innerhalb des Kabelschlauchs 20 ergibt.

Ist eine der Kühlmittelleitungen 23, 24 beschädigt, so kann, wie dies schematisch in Fig. 6 dargestellt ist, Kühlmittel K aus der jeweiligen Kühlmittelleitung 23, 24 austreten und in das Innere des Kabelschlauchs 20, insbesondere in die Zwischenräume Z zwischen den in dem Kabelschlauch 20 erstreckten Leitungen 22-24 eintreten. Ist das Kühlmittel K zumindest in begrenztem Maße elektrisch leitfähig (wie dies zum Beispiel bei Wasser der Fall ist), so wird über das Kühlmittel K lokal die elektrische Isolation zwischen den Fühlleitungen 25, 26 überbrückt, sodass bei Anliegen einer Spannungsdifferenz V zwischen den Fühlleitungen 25, 26 sich ein Stromfluss I über die Fühlleitungen 25, 26 ergibt, der auf Seiten der Steuereinrichtung 10 ausgewertet werden kann. Anhand eines Stromflusses kann somit eine Beeinträchtigung der Isolation zwischen den Fühlleitungen 25, 26 erkannt werden, um auf diese Weise auf ein Leck an einer der Kühlmittelleitungen 23, 24 zu schließen.

Die Steuereinrichtung 10 kann hierbei beispielsweise dazu ausgebildet sein, bei Detektion einer Veränderung der Leitfähigkeit innerhalb des Kabelschlauchs 20 den Stromfluss über die Lastleitungen 22 zu steuern. Beispielsweise kann ein Laststrom abgeschaltet werden, um auf diese Weise einen Ladevorgang zu beenden, wenn eine (unzulässige) Veränderung der Leitfähigkeitseigenschaften innerhalb des Kabelschlauchs 20 detektiert wird.

Bei dem Ausführungsbeispiel gemäß Fig. 3 und 4 sind zwei Fühlleitungen 25, 26 vorhanden, an die im Betrieb über die Steuereinrichtung 10 eine Spannungsdifferenz V angelegt wird, um anhand eines Stromflusses über die Fühlleitungen 25, 26 auf ein Leck an einer der Kühlmittelleitungen 23, 24 zu schließen. Beispielsweise kann an eine erste Fühlleitung 25 ein Messpotential angelegt werden, während die andere Fühlleitung 26 auf einem Massepotential liegt. Ergibt sich ein Stromfluss I, deutet dies auf eine Überbrückung der Isolation zwischen den Fühlleitungen 25, 26 hin.

Bei einem schematisch in Fig. 7 dargestellten Ausführungsbeispiel sind mehr als zwei Fühlleitungen 25, 26 vorgesehen. So ist bei dem Ausführungsbeispiel gemäß Fig. 7 in jedem Zwischenraum Z zwischen der zentralen, ersten Kühlmittelleitung 23 und den darum gruppierten zweiten Kühlmittelleitungen 24 sowie den Lastleitungen 22 eine Fühlleitung 25, 26 angeordnet. Die Fühlleitungen 25, 26 werden hierbei alternierend mit unterschiedlichen Potentialen beaufschlagt, beispielsweise indem jede Fühlleitung 25 auf einem Messpotential und jede Fühlleitung 26 auf einem Massepotential liegt. Benachbarte Fühlleitungen 25, 26 liegen somit auf unterschiedlichen Potentialen, sodass sich zwischen benachbarten Fühlleitungen 25, 26 eine Potentialdifferenz ergibt. Wird lokal die elektrische Isolation zwischen benachbarten Fühlleitungen 25, 26 überbrückt, so ergibt sich ein Stromfluss, der ausgewertet werden kann, um ein Kühlmittelleck innerhalb des Kabelschlauchs 20 zu erkennen.

Mittels der Verwendung von mehr als zwei Fühlleitungen 25, 26 ist eine räumlich enge Erkennung eines Kühlmittellecks innerhalb des Kabelschlauchs 20 möglich.

Der der Erfindung zugrunde liegende Gedanke ist nicht auf die vorangehend geschilderten Ausführungsbeispiele beschränkt, sondern lässt sich grundsätzlich auch in gänzlich andersgearteter Weise verwirklichen.

So kann die Anordnung von Lastleitungen und Kühlmittelleitungen in einem Kabelschlauch anders als bei den hier dargestellten Ausführungsbeispielen ausgeführt sein. Beispielsweise können in einem Kabelschlauch lediglich zwei Lastleitungen vorhanden sein.

Die Fühlleitungen sind elektrisch zumindest abschnittsweise nicht isoliert. Vorzugsweise sind die Fühlleitungen entlang ihrer gesamten Länge elektrisch nicht isoliert. Dies ist jedoch nicht zwingend. So kann abschnittsweise an den Fühlleitungen auch eine elektrisch isolierende Ummantelung vorgesehen sein, sodass die Fühlleitungen lediglich abschnittsweise freiliegen.

Die elektrischen Leiter der Fühlleitungen sind beispielsweise mit einer metallischen Oberflächenbeschichtung versehen, die die Fühlleitungen unempfindlich gegen Korrosion macht.

### Bezugszeichenliste

- 1: Ladestation
- 10: Steuereinrichtung
- 2: Ladekable
- 20: Kabelschlauch
- 200,201: Ende
- 21: Schirmleiter
- 22: Lastleitung
- 220: Leitungsader
- 221: Ummantelung
- 23, 24: Kühlmittelleitung
- 25, 26: Fühlleitung
- 27: Signalleitung
- 28: Füllelement
- 3: Ladestecker
- 30: Gehäuse
- 300, 301: Steckabschnitt
- 4: Fahrzeug
- 40: Ladebuchse
- I: Strom
- K: Kühlmittel
- L: Längsrichtung
- V: Messpotential (Spannung)
- Z: Zwischenraum

## Patentansprüche

1. Kabel (2) zum Übertragen eines elektrischen Stroms, mit
- einem Kabelschlauch (20),
- zumindest einer in dem Kabelschlauch (20) erstreckten elektrischen Lastleitung (22) zum Leiten eines elektrischen Stroms,
- zumindest einer in dem Kabelschlauch (20) erstreckten Kühlmittelleitung (23, 24) zum Führen eines Kühlmittels, und
- zumindest einer in dem Kabelschlauch (20) erstreckten Fühlleitung (25, 26) zum Erfassen eines eine Veränderung der elektrischen Leitfähigkeit in dem Kabelschlauch (20) anzeigenden Messsignals,
**dadurch gekennzeichnet, dass** die elektrisch leitende Fühlleitung (25, 26) zumindest abschnittsweise nicht elektrisch isoliert ist und dass das Kabel (2) eine zentrale, erste Kühlmittelleitung (23) aufweist, um die herum zumindest eine zweite Kühlmittelleitung (24) und zumindest eine elektrische Lastleitung (22) gruppiert sind, wobei die zumindest eine Fühlleitung (25, 26) in einem Zwischenraum (Z) zwischen der zentralen, ersten Kühlmittelleitung (23) und der zumindest einen zweiten Kühlmittelleitung (24) oder der zumindest einen elektrischen Lastleitung (22) erstreckt ist.

2. Kabel (2) nach Anspruch 1, **dadurch gekennzeichnet, dass** das Kabel (2) eine in dem Kabelschlauch (20) erstreckte erste Fühlleitung (25) und eine von der ersten Fühlleitung (25) beabstandet in dem Kabelschlauch (20) erstreckte zweite Fühlleitung (26) aufweist.

3. Kabel (2) nach Anspruch 2, **dadurch gekennzeichnet, dass** die erste Fühlleitung (25) und die zweite Fühlleitung (26) in dem Kabelschlauch (20) nicht elektrisch miteinander kontaktiert sind.

4. Kabel (2) nach einem der vorangehenden Ansprüche, **dadurch gekennzeichnet, dass** die zumindest eine Fühlleitung (25, 26) an eine Steuereinrichtung (10) angeschlossen ist, die ausgebildet ist, ein Messpotential (V) an die zumindest eine Fühlleitung (25, 26) anzulegen, um ein eine Veränderung der Leitfähigkeit in dem Kabelschlauch (20) anzeigendes Messsignal zu erfassen.

5. Kabel (2) nach Anspruch 4, **dadurch gekennzeichnet, dass** die Steuereinrichtung (10) ausgebildet ist, einen über die zumindest eine Lastleitung (22) fließenden Strom abzuschalten, wenn eine Veränderung der Leitfähigkeit in dem Kabelschlauch (20) detektiert wird.

6. Kabel (2) nach einem der vorangehenden Ansprüche, **dadurch gekennzeichnet, dass** das Kabel (2) an einem ersten Ende (200) mit einem Steckverbinderteil (3) und an einem dem ersten Ende (200) abgewandten, zweiten Ende (201) mit einer Ladestation (1) zum Aufladen eines Elektrofahrzeugs (4) verbunden ist.

## Claims

1. Cable (2) for transmitting an electric current, comprising
- a cable conduit (20),
- at least one electrical load line (22), which extends in the cable conduit (20), for conducting an electric current,
- at least one coolant line (23, 24), which extends in the cable conduit (20), for guiding a coolant, and
- at least one sensing line (25, 26), which extends in the cable conduit (20), for capturing a measurement signal which indicates a change in the electrical conductivity in the cable conduit (20),
**characterized in that** the electrically conductive sensing line (25, 26) is not electrically insulated at least in sections, and **in that** the cable (2) has a central, first coolant line (23) around which at least one second coolant line (24) and at least one electrical load line (22) are grouped, wherein the at least one sensing line (25, 26) extends in an intermediate space (Z) between the central, first coolant line (23) and the at least one second coolant line (24) or the at least one electrical load line (22).

2. Cable (2) according to Claim 1, **characterized in that** the cable (2) has a first sensing line (25), which extends in the cable conduit (20), and a second sensing line (26), which extends in the cable conduit (20) at a distance from the first sensing line (25).

3. Cable (2) according to Claim 2, **characterized in that** the first sensing line (25) and the second sensing line (26) are not electrically contact-connected to one another in the cable conduit (20).

4. Cable (2) according to one of the preceding claims, **characterized in that** the at least one sensing line (25, 26) is connected to a control device (10) which is designed to apply a measurement potential (V) to the at least one sensing line (25, 26) in order to capture a measurement signal which indicates a change in the conductivity in the cable conduit (20).

5. Cable (2) according to Claim 4, **characterized in that** the control device (10) is designed to cut off a current flowing via the at least one load line (22) when a change in the conductivity in the cable conduit (20) is detected.

6. Cable (2) according to one of the preceding claims, **characterized in that** the cable (2) is connected to a plug-in connector part (3) at a first end (200) and to a charging station (1) for charging an electric vehicle (4) at a second end (201) which is averted from the first end (200) .

## Revendications

1. Câble (2) destiné à la transmission d'un courant électrique, comprenant
- une gaine de câble (20),
- au moins une ligne de charge (22) électrique qui s'étend dans la gaine de câble (20) pour conduire un courant électrique,
- au moins une conduite de fluide de refroidissement (23, 24) qui s'étend dans la gaine de câble (20) pour le passage d'un fluide de refroidissement, et
- au moins une ligne de détection (25, 26) qui s'étend dans la gaine de câble (20) pour acquérir un signal de mesure indiquant une modification de la conductivité électrique dans la gaine de câble (20),
**caractérisé en ce que** la ligne de détection (25, 26) électriquement conductrice n'est pas isolée électriquement au moins dans certaines portions et **en ce que** le câble (2) possède une première conduite de fluide de refroidissement (23) centrale autour de laquelle sont groupées au moins une deuxième conduite de fluide de refroidissement (24) et au moins une ligne de charge (22) électrique, l'au moins une ligne de détection (25, 26) s'étendant dans un espace intermédiaire (Z) entre la première conduite de fluide de refroidissement (23) centrale et l'au moins une deuxième conduite de fluide de refroidissement (24) ou l'au moins une ligne de charge (22) électrique.

2. Câble (2) selon la revendication 1, **caractérisé en ce que** le câble (2) possède une première ligne de détection (25) qui s'étend dans la gaine de câble (20) et une deuxième ligne de détection (26), espacée de la première ligne de détection (25), qui s'étend dans la gaine de câble (20).

3. Câble (2) selon la revendication 2, **caractérisé en ce que** la première ligne de détection (25) et la deuxième ligne de détection (26) ne sont pas mises en contact électrique l'une avec l'autre dans la gaine de câble (20) .

4. Câble (2) selon l'une des revendications précédentes, **caractérisé en ce que** l'au moins une ligne de détection (25, 26) est raccordée à un dispositif de commande (10), lequel est configuré pour appliquer un potentiel de mesure (V) à l'au moins une ligne de détection (25, 26) afin d'acquérir un signal de mesure indiquant une modification de la conductivité électrique dans la gaine de câble (20).

5. Câble (2) selon la revendication 4, **caractérisé en ce que** le dispositif de commande (10) est configuré pour couper le courant qui circule par le biais de l'au moins une ligne de charge (22) lorsqu'une modification de la conductivité électrique dans la gaine de câble (20) est détectée.

6. Câble (2) selon l'une des revendications précédentes, **caractérisé en ce que** le câble (2) est relié par sa première extrémité (200) à une partie de connecteur à enfichage (3) et par une deuxième extrémité (201), opposée à la première extrémité (200), à une station de charge (1) servant à la charge d'un véhicule électrique (4).
